Europäisches Patentamt

European Patent Office

Office européen des brevets

(11) Veröffentlichungsnummer: **0 012 876**
**A1**

## (12) EUROPÄISCHE PATENTANMELDUNG

(21) Anmeldenummer: 79104821.8

(22) Anmeldetag: 01.12.79

(51) Int. Cl.³: **H 03 H 11/12**

(30) Priorität: 20.12.78 DE 2854978

(43) Veröffentlichungstag der Anmeldung:
09.07.80 Patentblatt 80/14

(84) Benannte Vertragsstaaten:
AT BE DE FR GB IT LU NL SE

(71) Anmelder: ROBERT BOSCH GMBH
Postfach 50
D-7000 Stuttgart 1(DE)

(72) Erfinder: Bitar, Omar, Dipl.-Ing.
Kaiserdamm 111
D-1000 Berlin 19(DE)

(74) Vertreter: Schmidt, Hans-Ekhardt
Robert Bosch GmbH Geschäftsbereich Elektronik
Patent- und Lizenzabteilung Forckenbeckstrasse 9-13
D-1000 Berlin 33(DE)

(54) Aktives NF-Bandpassfilter.

(57) Es wird ein aktives NF-Bandpaßfilter vorgeschlagen, das drei Operationsverstärker (13, 16, 22) enthält, von denen einer als Umkehrstufe und die beiden anderen als Integratoren geschaltet sind. Von den die Mittenfrequenz des Bandpaßfilters bestimmenden Bauelementen ($C_1$, $C_2$, $R_1$ ... $R_4$) wird zum Einstellen der Mittenfrequenz lediglich der elektrische Wert eines Bauelements ($R_3$) verändert.

Fig. 1

EP 0 012 876 A1

42/78
EK/PLI Scht/Li
15. Dez. 1978


ROBERT BOSCH GMBH, 7000 Stuttgart


Aktives NF-Bandpaßfilter

Stand der Technik

Die Erfindung geht aus von einem aktiven NF-Bandpaßfilter
nach der Gattung des Hauptanspruchs.

Es ist schon ein aktives NF-Bandpaßfilter bekannt (Special
Function Data Book, Firma National Semiconductor (UK) Ltd.,
April 1976, Seite 10-3), das eine Reihenschaltung aus drei
Operationsverstärkern, von denen der erste als Umkehrverstärker und die beiden folgenden als Integratoren geschaltet
sind, enthält. Die Frequenz des Bandpaßfilters bestimmen
zwei Kondensatoren und vier Widerstände. Durch gleichzeitiges
Verändern des Widerstandswertes zweier Widerstände läßt sich
das Bandpaßfilter auf verschiedene Frequenzen abstimmen, wobei Güte und Ausgangsspannung des Bandpaßfilters im Abstimmbereich weitgehend konstant bleiben.

## Vorteile der Erfindung

Das erfindungsgemäße aktive NF-Bandpaßfilter mit den kennzeichnenden Merkmalen des Hauptanspruchs hat den Vorteil,
daß der Widerstandswert nur eines einzigen Widerstandes
verändert zu werden braucht, um die Mittenfrequenz des
Bandpaßfilters einzustellen. Wird eine bestimmte Dimensionierung der frequenzbestimmenden Bauelemente eingehalten,
dann verändert sich durch die Einstellung die Güte des
Bandpaßfilters und dessen Ausgangsspannung nur unwesentlich.

Durch die in den Unteransprüchen aufgeführten Maßnahmen
sind vorteilhafte Weiterbildungen und Verbesserungen des
im Hauptanspruch angegebenen NF-Bandpaßfilters möglich.
Besonders vorteilhaft ist es, wenn zwecks stufenweiser Einstellung der Mittenfrequenz des Bandpaßfilters der Widerstand aus einer Reihenschaltung mit mindestens zwei Widerständen besteht, wenn zwischen je zwei benachbarten Widerständen der Reihenschaltung ein Abgriff vorgesehen ist und
wenn jeweils ein der gewünschten Mittenfrequenz entsprechender Abgriff mittels einer Schalteinrichtung auswählbar ist.

## Zeichnung

Zwei Ausführungsbeispiele der Erfindung sind in der Zeichnung anhand zweier Figuren dargestellt und in der nachfolgenden Beschreibung näher erläutert. Die Zeichnung zeigt in

Fig. 1    ein Schaltbild eines erfindungsgemäßen, stufenweise
          umschaltbaren Bandpaßfilters und

Fig. 2    ein Schaltbild eines erfindungsgemäßen Bandpaßfilters
          nach Fig. 1, das für ein Fünftonfolge-Selektivrufsystem konzipiert ist.

## Beschreibung der Erfindung

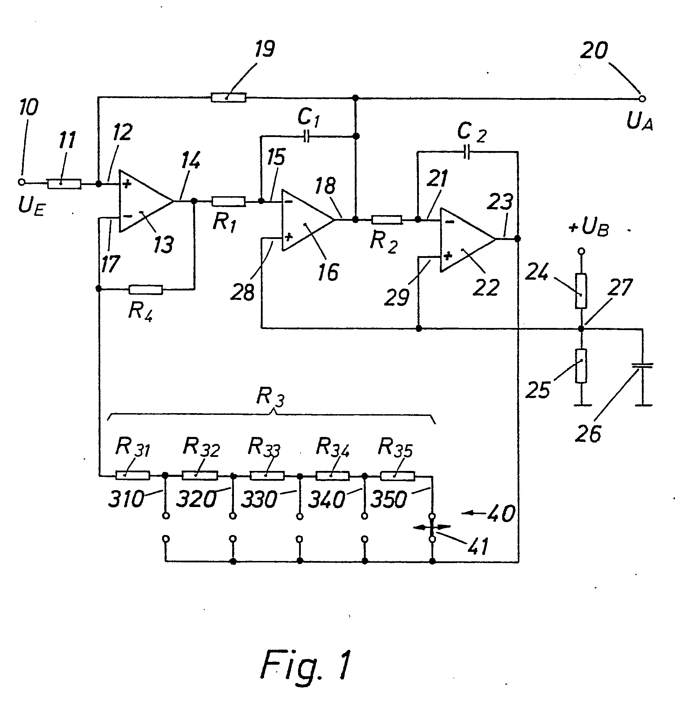

Ein in Fig. 1 gezeigtes erfindungsgemäßes aktives NF-Bandpaßfilter hat einen Eingang 10, der über einen Widerstand 11
mit einem nichtinvertierenden Eingang 12 eines ersten Operationsverstärkers 13 verbunden ist. Zwischen einem Ausgang 14
des ersten Operationsverstärkers und einem invertierenden
Eingang 15 eines zweiten Operationsverstärkers 16 liegt ein
Widerstand $R_1$. Der Ausgang 14 des ersten Operationsverstärkers ist ferner über einen Widerstand $R_4$ mit einem invertierenden Eingang 17 des ersten Operationsverstärkers 13 verbunden. Zwischen dem invertierenden Eingang 15 des zweiten
Operationsverstärkers 16 und dessen Ausgang 18 liegt ein
Kondensator $C_1$  und zwischen dem Ausgang 18 des zweiten
Operationsverstärkers und dem nichtinvertierenden Eingang 12
des ersten Operationsverstärkers ein Widerstand 19. Der Ausgang 18 des zweiten Operationsverstärkers bildet gleichzeitig
den Ausgang 20 des NF-Bandpaßfilters. An den Ausgang 18 des
zweiten Operationsverstärkers 16 schließt sich ein Widerstand $R_2$ an, der erstens mit einem invertierenden Eingang 21
eines dritten Operationsverstärkers 22 und zweitens über
einen Kondensator $C_2$ mit einem Ausgang 23 des dritten Operationsverstärkers verbunden ist.

Zwischen den Polen einer Betriebsspannungsquelle mit der
Spannung $U_B$ liegt ein Spannungsteiler aus zwei Widerständen
24 und 25, von denen der Widerstand 25 durch einen Kondensator 26 überbrückt ist. Ein zwischen den beiden Widerständen
24 und 25 liegender Abgriff 27 ist mit nichtinvertierenden
Eingängen 28, 29 der Operationsverstärker 16 und 22 verbunden.

Ein Widerstand $R_3$ verbindet den Ausgang 23 des dritten Operationsverstärkers 22 mit dem invertierenden Eingang 17 des
ersten Operationsverstärkers 13. Der Widerstand $R_3$ besteht
aus einer Reihenschaltung aus fünf Widerständen $R_{31}$ ... $R_{35}$.

Zwischen je zwei benachbarten Widerständen der Reihenschaltung sowie an dem freien Ende des fünften Widerstandes $R_{35}$ befindet sich je ein Abgriff 310, 320, 330,
340 und 350. Die Abgriffe gehören zu einem Umschalter 40,
mit dessen beweglichen Kontakt 41 jeweils ein Abgriff
und damit eine bestimmte Zahl von Widerständen der Reihenschaltung eingeschaltet werden kann.

Damit die vorstehend beschriebene Schaltung einwandfrei
arbeitet, müssen folgende Bedingungen erfüllt sein. Bei
dem aktiven NF-Bandpaßfilter nach Fig. 1 ist der erste
Operationsverstärker 13 als Umkehrverstärker mit dem
Widerstand $R_4$ geschaltet, während der zweite Operationsverstärker 16 und der dritte Operationsverstärker 22 mit
den Kondensatoren $C_1$ bzw. $C_2$ Integratoren bilden. Diese
Art der Schaltung ist an sich bekannt, so daß eine nähere
Erläuterung der Arbeitsweise nicht erforderlich ist. Die
frequenzbestimmenden Bauelemente der Schaltung sind die
Kondensatoren $C_1$, $C_2$ und die Widerstände $R_1$, $R_2$, $R_3$ und $R_4$.
Für die Abstimmung des erfindungsgemäßen NF-Bandpaßfilters
gilt folgende Beziehung:

$$f = \frac{1}{2\pi \cdot \sqrt{R_1 \cdot R_2 \cdot C_1 \cdot C_2 \cdot \frac{R_3}{R_4}}} \cdot$$

Bei einer ganz bestimmten Wahl der frequenzbestimmenden Bauelemente gibt es ein Optimum, bei dem sich das Filter in
einem begrenzten Frequenzbereich zwischen etwa 1000 und
3000 Hz mit nur einem Widerstand $R_3$ oder $R_4$ bei annähernd
konstanter Güte durchstimmen läßt.

Für die Festlegung des Frequenzbereichs und die Dimensionierung der frequenzbestimmenden Bauelemente $C_1$, $C_2$, $R_1$, $R_2$, $R_3$ und $R_4$ gelten folgende Beziehungen:

Ist die obere Grenzfrequenz $f_{max}$ des Durchstimmbereichs des Bandpaßfilters gegeben, so erhält man für die untere Grenzfrequenz

$$f_{min} \approx 0{,}35 \cdot f_{max}.$$

Für die Kondensatoren $C_1$, $C_2$ gilt unter der Voraussetzung, daß $C_1 = C_2$ ist, die Beziehung

$$C = \frac{4200 \cdot 10^{-9}}{f_{max}}.$$

In dieser Beziehung sind der Kapazitätswert in Farad und die Frequenz in Hertz einzusetzen.

Setzt man für die Widerstände $R_1 = R_2 = R$, dann erhält man für

$$R = \frac{1}{f_{max} \cdot \pi \cdot C}.$$

Für $R_4$ gilt die Beziehung

$$R_4 \approx \frac{R}{7{,}5}$$

und für $R_3$

$$R_3 \approx \frac{R_4}{(2 \cdot \pi \cdot R \cdot C \cdot f_M)^2}.$$

Mit $f_M$ ist die gewünschte Mittenfrequenz des Bandpaßfilters bezeichnet. Die Beziehungen für die Widerstandswerte der Widerstände $R_4$ und $R_3$ gelten für den Fall, daß der Widerstand $R_3$ der einstellbare Widerstand sein soll.

Wird dagegen der Widerstand $R_4$ als Widerstand zum Einstellen der Mittenfrequenz veränderbar ausgeführt, so gilt

$$R_3 \approx \frac{R}{7,5}$$

und

$$R_4 = R_3 \, (2\pi \cdot R \cdot C \cdot f_M)$$

In einem praktisch erprobten aktiven NF-Bandpaßfilter ergibt sich bei einem Durchstimmbereich von 1060 bis 2800 Hz bei der angegebenen Einstellung der Mittenfrequenz des Bandpaßfilters eine Änderung der Güte von höchstens 1 % bei einer Güte von 24. Diese Abweichung ist für fast alle Anwendungen eines aktiven NF-Bandpaßfilters zulässig.

Ein Hauptanwendungsgebiet für das aktive NF-Bandpaßfilter ist das Mehrtonfolge-Selektivrufsystem. Bei diesem System kennzeichnet eine mehrstellige Tonfolge, zum Beispiel eine Fünftonfolge, einen Teilnehmer am Sprechfunkverkehr. Jede Stelle des Selektivrufs kann beispielsweise eine von zehn Tonfrequenzen aufweisen. Zusätzlich ist noch eine elfte und eine zwölfte Tonfrequenz für einen sogenannten Wiederholton und einen Notrufton vorgesehen.

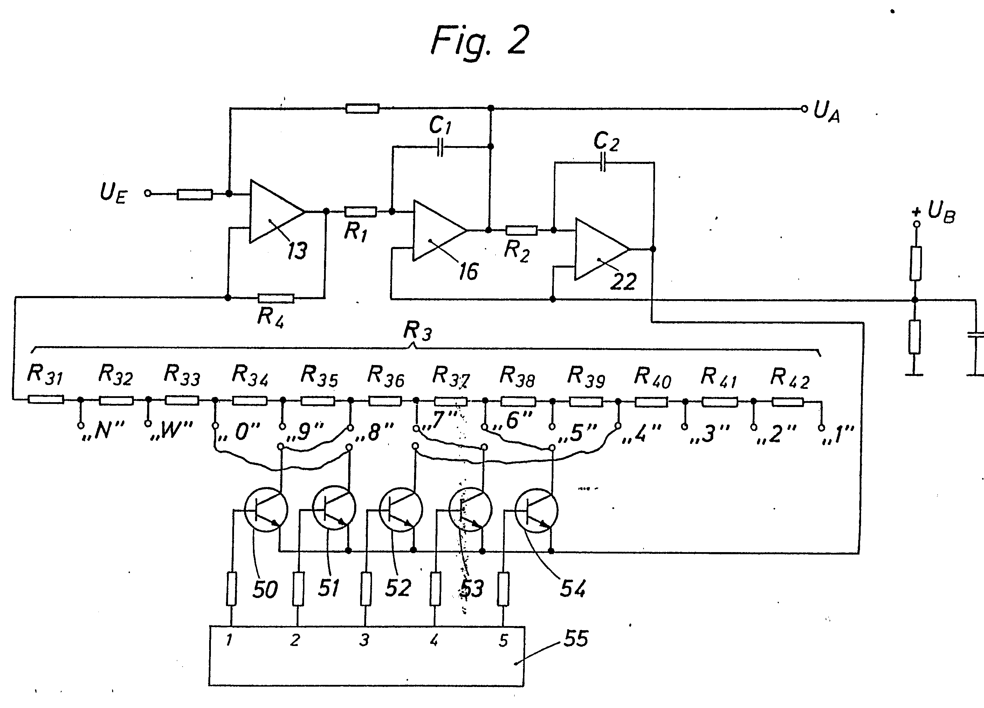

Das Schaltbild in Fig. 2 zeigt eine Anwendung des Fünftonfolge-Selektivrufsystems in Verbindung mit einem aktiven Bandpaßfilter nach Fig. 1.

Während die Operationsverstärker 13, 16 und 22 in der gleichen Weise wie in Fig. 1 geschaltet sind, besteht der Widerstand $R_3$ in dem Ausführungsbeispiel nach Fig. 2 aus einer Reihenschaltu von zwölf Widerständen $R_{31}$ ... $R_{42}$. Die Abgriffe sind in diese Fall mit "1" bis "9", "0", "W" und "N" bezeichnet, entsprechen den Tonfrequenzen $f_1$ bis $f_{10}$ für die Ziffern 1 bis 10 und entsprechend der Frequenz $f_{11}$ für einen Wiederholton und $f_{12}$ für einen Notrufton.

Soll ein bestimmter Fonftonfolge-Selektivruf erzeugt werden,
so sind die der gewünschten Ziffernfolge entsprechenden Abgriffe mit dem Kollektor je eines Transistors 50 bis 54 verbunden. Die Transistoren 50 bis 54 sind vorzugsweise bipolare
Transistoren, die durch eine elektronische Zählschaltung 55
nacheinander angesteuert werden. Beispielsweise wird bei dem
ersten Zählschritt der Zählschaltung 55 der Transistor 50 in
den leitenden Zustand gesteuert, während die anderen Transistoren 51 bis 54 gesperrt sind. Der Kollektor des leitenden
Transistors 50 steht über eine Leitungsverbindung mit dem
Abgriff "8" in Verbindung, wodurch der Widerstand $R_3$ des
Bandpaßfilters durch eine Reihenschaltung aus den Widerständen $R_{31}$ bis $R_{35}$ gebildet wird. Mit diesem Widerstand $R_3$ ist
das Bandpaßfilter auf eine Mittenfrequenz $f_M$ abgestimmt, die
der Tonfrequenz $f_8$ entspricht.

Der nächste Zählschritt der elektronischen Zählschaltung 55
bewirkt ein Durchschalten der Kollektor-Emitterstrecke des
Transistors 51, während die anderen Transistoren 50, 52, 53
und 54 gesperrt sind. Über eine Verbindungsleitung zwischen
dem Kollektor des Transistors 51 und dem Abgriff "O" wird ein
Widerstand $R_3$ eingeschaltet, der aus einer Reihenschaltung der
Widerstände $R_{31}$ bis $R_{33}$ besteht. Mit diesem Widerstand $R_3$ ist
das Bandpaßfilter auf die Tonfrequenz $f_{11}$ abgestimmt, die dem
Wiederholton entspricht.

Mit jedem neuen Zählschritt der Zählschaltung wird ein weiterer Transistor und damit eine weitere Tonfrequenz eingeschaltet.

42/78
EK/PLI Scht/Li
15. Dez.  1978

ROBERT BOSCH GMBH, 7000 Stuttgart


Ansprüche


1. Aktives NF-Bandpaßfilter mit einer Reihenschaltung
   aus einem ersten Operationsverstärker, der als
   Umkehrverstärker geschaltet ist, und einem zweiten
   und einem dritten Operationsverstärker, die als
   Integratoren geschaltet sind, wobei zwei Kondensatoren und vier Widerstände die Mittenfrequenz des
   Bandpaßfilters bestimmen, von denen der erste Widerstand zwischen dem Ausgang des ersten und einem Eingang des zweiten Operationsverstärkers, der zweite
   Widerstand zwischen dem Ausgang des zweiten und
   einem Eingang des dritten Operationsverstärkers, der
   dritte Widerstand zwischen dem Ausgang des dritten
   und einem Eingang des ersten Operationsverstärkers
   und der vierte Widerstand zwischen dem Ausgang und
   dem Eingang des ersten Operationsverstärkers liegen,
   dadurch gekennzeichnet, daß die Mittenfrequenz ($f_M$)
   des Bandpaßfilters durch Verändern des Widerstandswertes des dritten Widerstandes ($R_3$) oder des vierten Widerstandes ($R_4$) innerhalb eines Frequenzbereiches, dessen untere und obere Grenzfrequenz
   ($f_{min}$, $f_{max}$) um etwa den Faktor 3 differieren, bei
   einer bestimmten Dimensionierung der frequenzbestimmenden Bauelemente ohne merkliche Änderung der Güte
   und der Ausgangsspannung des Bandpaßfilters einstellbar ist.

                                                    - 2 -

2. Aktives Bandpaßfilter nach Anspruch 1, dadurch gekennzeichnet, daß für die Dimensionierung der frequenzbestimmenden Bauelemente ($C_1$, $C_2$, $R_1$ ... $R_4$) folgende Beziehungen gelten:

(1) $\quad C_1 = C_2 = C \approx \dfrac{4200 \cdot 10^{-9}}{f_{max}}$ $\quad$ ($f_{max}$ = obere Grenzfrequen

(2) $\quad R_1 = R_2 = R = \dfrac{1}{f_{max} \cdot \pi \cdot C}$

(3) $\quad R_4 \approx \dfrac{R}{7,5}$ $\quad$ (wenn mit $R_3$ abgestimmt wird)

(4) $\quad R_3 = \dfrac{R_4}{(2 \cdot \pi \cdot R \cdot C \cdot f_M)^2}$ $\quad$ ($f_M$ = Mittenfrequenz)

(5) $\quad R_3 \approx \dfrac{R}{7,5}$ $\quad$ (wenn mit $R_4$ abgestimmt wird)

(6) $\quad R_4 = R_3 \cdot (2 \cdot \pi \cdot R \cdot C \cdot f_M)^2$.

3. Aktives Bandpaßfilter nach Anspruch 1 oder 2, dadurch gekennzeichnet, daß zwecks stufenweiser Einstellung der Mittenfrequenz ($f_M$) des Bandpaßfilters der Widerstand ($R_3$ oder $R_4$) aus einer Reihenschaltung mit mindestens zwei Widerständen ($R_{31}$, $R_{32}$ ...) besteht, daß zwischen je zwei benachbarten Widerständen ($R_{31}$, $R_{32}$) der Reihenschaltung ein Abgriff (310, 320 ...) vorgesehen ist und daß jeweils ein der gewünschten Mittenfrequenz ($f_M$) entsprechender Abgriff mittels einer Schalteinrichtung (40) auswählbar ist.

4. Aktives Bandpaßfilter nach Anspruch 1 oder 2, dadurch gekennzeichnet, daß zwecks kontinuierlicher Einstellung der Mittenfrequenz ($f_M$) des Bandpaßfilters ein Einstellwiderstand vorgesehen ist.

5. Aktives Bandpaßfilter nach Anspruch 1, 2 oder 3, dadurch gekennzeichnet, daß die Schalteinrichtung mit bipolaren Transistoren (50, 51 ...) aufgebaut ist, von denen je ein Transistor je einem Abgriff zugeordnet ist.

6. Aktives Bandpaßfilter nach einem oder mehreren der Ansprüche 1 bis 5, gekennzeichnet durch die Anwendung bei einem Mehrtonfolge-Selektivrufsystem.

7. Aktives Bandpaßfilter nach Anspruch 5 oder 6, dadurch gekennzeichnet, daß die bipolaren Transistoren (50, 51 ...) mittels einer elektronischen Zählschaltung (55) ansteuerbar sind.

0012876

*Fig. 1*

0012876

Fig. 2

$+U_B$

$U_A$

$U_E$

$C_2$

22

$R_2$

16

$C_1$

$R_1$

13

$R_4$

$R_3$

$R_{42}$ $R_{41}$ $R_{40}$ $R_{39}$ $R_{38}$ $R_{37}$ $R_{36}$ $R_{35}$ $R_{34}$ $R_{33}$ $R_{32}$ $R_{31}$

„1" „2" „3" „4" „5" „6" „7" „8" „9" „0" „W" „N"

50 51 52 53 54

55

1 2 3 4 5

Europäisches Patentamt

## EUROPÄISCHER RECHERCHENBERICHT

| | EINSCHLÄGIGE DOKUMENTE | | KLASSIFIKATION DER ANMELDUNG (Int.Cl. ³) |
|---|---|---|---|
| Kategorie | Kennzeichnung des Dokuments mit Angabe, soweit erforderlich, der maßgeblichen Teile | betrifft Anspruch | |
| | INTERNATIONAL JOURNAL OF ELEC-TRONICS, Band 41, Nr. 4, Oktober 1976 London GB J.J. HILL: "Digital control of active filter characteristics". Seiten 405-410. <br><br> * Figur 2; Seiten 406-409: "3-Basic configuration" * <br><br> -- | 1,4 | H 03 H 11/12 |
| | 1969 WESCON TECHNICAL PAPERS (presented at the Western Electronic Show and Convention, August 19-22, 1969) Teil 5; Components and Microelectronics; North Hollywood, US D. HOLLENBECK : "Multiloop negative feedback active filters using thick film integrated circuit technique", Vortrag 4/4, Seiten 1-5. <br><br> * Figur 1; Seiten 1-2 * <br><br> -- | 1,4 | **RECHERCHIERTE SACHGEBIETE (Int. Cl. ³)** <br><br> H 03 H 11/12 <br> 11/24 <br> 7/25 <br> 7/24 |
| | US - A - 3 715 678 (H.S. REICHARD) <br> * Figur 2; Spalte 3, Zeilen 8-35 * <br><br> -- | 1,4 | |
| | US - A - 3 760 287 (C.A. HARRIS) <br> * Figuren 1,2,4; Spalte 3, Zeilen 25-39; Spalte 4, Zeilen 47-56; Spalte 7, Zeilen 4-36 * <br><br> -- | 1,3 | **KATEGORIE DER GENANNTEN DOKUMENTE** <br><br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument |
| | FR - A - 1 559 041 (G. FERRIEU) <br> * Figur 1; Seite 2, linke Spalte, Zeile 56 bis rechte Spalte, Zeile 21 * | 5,7 | |

---- 
Der vorliegende Recherchenbericht wurde für alle Patentansprüche erstellt.

&: Mitglied der gleichen Patent-familie. übereinstimmendes Dokument

| Recherchenort | Abschlußdatum der Recherche | Prüfer |
|---|---|---|
| Den Haag | 26-03-1980 | COPPIETERS |

EPA form 1503.1 06.78